# EUROPEAN PATENT SPECIFICATION

(11) **EP 0 441 368 B1**
(45) Date of publication and mention of the grant of the patent: **08.05.1996**
(21) Application number: 91101670.7
(22) Date of filing: 07.02.1991
(51) Int. Cl.: C23C 14/22, C23C 14/34, C23C 14/56

(54) **Method and device for removing excess material from a sputtering chamber**
Verfahren und Vorrichtung zum Entfernen von überflüssigem Material von einer Kammer zur Sputtern
Méthode et dispositif pour enlever le matériau en excès d'une chambre de dépôt par pulverisation

(30) Priority: 09.02.1990 US 477788
(43) Date of publication of application: 14.08.1991
(73) Proprietor: APPLIED MATERIALS INC., Santa Clara California 95052 (US)
(72) Inventor: Somekh, Sasson, Los Altos Hills, California 94022 (US); Maydan, Dan, Los Altos Hills, California 94022 (US)
(74) Representative: Kahler, Kurt, Dipl.-Ing.

(56) References cited:
- EP-A- 0 296 891
- US-A- 4 786 352
- IBM TECHNICAL DISCLOSURE BULLETIN, vol. 20, no. 3, August 1977, pages 1177- 1178, New York, US; W.C. LESTER et al.: "Sputtering cathode glow suppression shields"

## Description

The present invention concerns a method and device for removing excess material from a sputtering chamber according the precharacterizing part of claim 1 and 6, respectively.

### Background of the Art

In physical vapor deposition (PVD) processes a target material, for example Tungsten, is bombarded by a gas, for example Argon. Material from the target is dislodged and sputters onto a wafer.

A PVD chamber generally includes shields in the area immediately around a wafer. The shields prevent excess material sputtering from the target from contaminating the remainder of the PVD chamber.

The build-up of excess material on the shields eventually results in flaking. At this point it is usually necessary to service the PVD chamber by replacing the shield. If shield replacement needs to be done at approximately the same time as target replacement, the service to the shield may be performed without too much inconvenience. However, if it the shield needs to be replaced much more often than the target, this can result in extra down-time of a system which can seriously impair production throughput.

Several methods have been tried to reduce flaking and thereby lengthen the time between shield replacement. For example, some shields have been designed to have a specific expansion coefficient. Additionally, the surface of shields has been treated, for example, by sandblasting. Adhesion layers also have been laid down to prevent flaking. Finally, shield design may be simplified to facilitate easy replacement.

The article "Sputtering cathode glow suppression shields" in IBM TECHNICAL DISCLOSURE BULLETIN, vol. 20, no. 3, August 1977, pages 1177-1178, New York, US; W. C. LESTER et al. discloses the cleaning of a shield by sputtering it. The material removed from the shield is a solid which deposits on the sputtering chamber walls and onto the target.

US-A-4 786 352 discloses a process for cleaning a CVD chamber by reactive plasma etching. A RF power source is used to create a plasma of gaseous reactive species which etch unwanted deposit from the interior surfaces of the chamber and/or the surfaces of tooling or substrates disposed in the chamber.

### Summary of the Invention

It is the object of the present invention to provide a method for cleaning of excess target material deposited on a shield in a sputtering chamber.

It is a further object of the invention to provide a device for implementing the method of the invention.

These objects are achieved by the method of claim 1 and by the device of claim 6, respectively.

According to the invention, in principle, during an in situ cleaning cycle, a vacuum is created in the physical vapor deposition (PVD) chamber. A gas mixture which includes a reactive gas is introduced into the PVD chamber. The reactive gas is activated by plasma discharge, and is pumped out of the chamber with the reaction products.

The present invention allows for in situ cleaning of shields in a PVD chamber. In situ cleaning of shields in chemical vapor deposition (CVD) processes is easier than in PVD chambers. This is because PVD processes typically are done in a high vacuum, which is not conducive to using etchants to clean a shield. Additionally, in the prior art, shields have often included many parts making it difficult to uniformly etch material from them. Also, in order to effectively etch a shield without removing an excess amount of the target, there must be some way to increase bombardment of the etchant on the shield while decreasing bombardment of the etchant on the target. The preferred embodiment of the present invention solves all of the issues. In the preferred embodiment of the present invention, during a cleaning cycle the vacuum which is created in the PVD chamber is less than that used for typical PVD processes. The shield is designed from a few pieces of conductive material providing for uniform etching. Also, during the cleaning cycle, a negative voltage potential is placed on the shield so that there is increased bombardment of etchant on the shield.

Alternative embodiments of the present invention include an upstream activation of the reactive gas in a special activation chamber by applying a radio frequency voltage or a DC voltage to an electrode to activate the reactive gas.

### Brief Description of the Drawings

- Fig. 1: is a simplified block diagram showing a physical vapor deposition chamber and related circuitry according to the preferred embodiment of the present invention;
- Fig. 2: shows a perspective view of a disassembled physical vapor deposition chamber in accordance with the preferred embodiment of the present invention; and
- Fig. 3: shows a modification to the physical vapor deposition chamber and circuitry shown in Fig. 1 to allow for upstream activation of reactive gas in accordance with an embodiment of the present invention.

### Description of the Preferred Embodiment

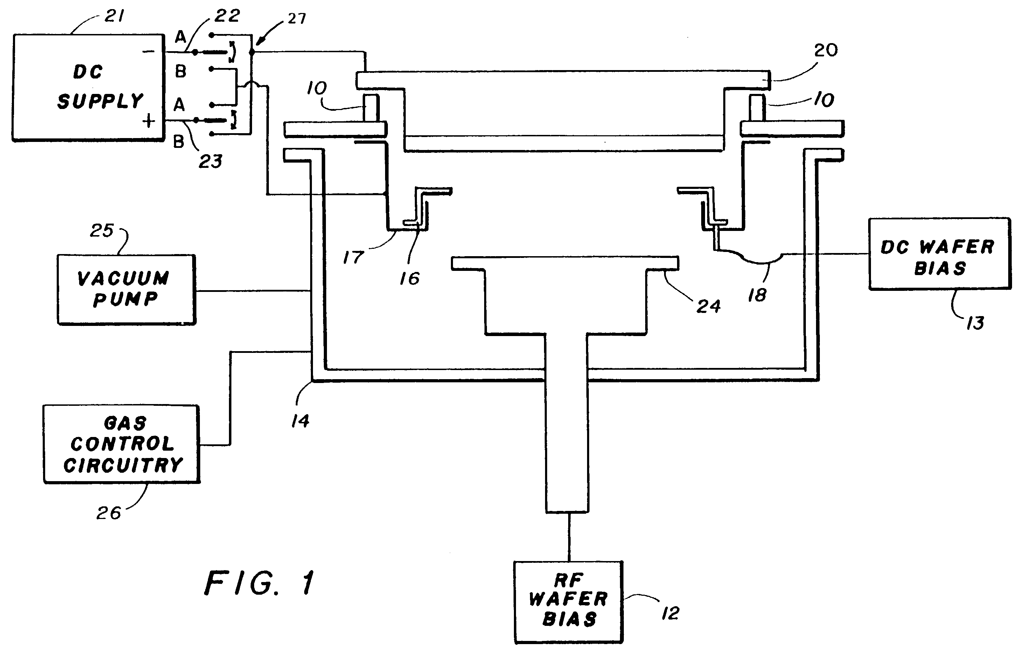

In Fig. 1, a physical vapor deposition (PVD) chamber 14 includes a movable wafer table 24. During the course of processing a specimen, i. e., a wafer, is placed on wafer table 24. Wafer table 24 is raised through a sleeve 16 and a shield 17 to a processing location. An RF wafer bias circuit 12 provides an RF bias voltage to the wafer. A DC wafer bias circuit 13 provides a DC bias to the wafer through a line 18.

Gas control circuitry 26 controls gas flow in and out of chamber 14. A vacuum pump 25 is used to create a vacuum in PVD chamber 14 during processing of wafers.

A target 20 may be composed of, for example, Titanium Tungsten. Target 20 is electrically isolated from shield 17 and the rest of PVD chamber 14 by insulation 10. A DC power supply 21 establishes a voltage potential between shield 17 and target 20. A switch 27 alters the polarity of the voltage potential.

DC power supply 21 is floating so that neither cathode 22 nor anode 23 is grounded to PVD chamber 14.

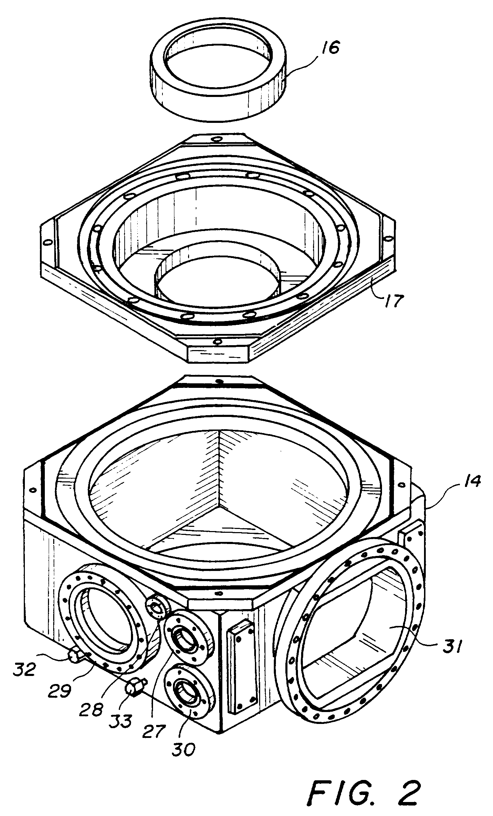

When wafers are being processed switch 27 connects cathode 22 of DC power supply 21 to target 20. Process switch 27 connects anode 23 to shield 17. DC power supply 21 is used because gas in the form of plasma will be accelerated toward whatever surface is connected to cathode 22. Argon gas is pumped through a port 28 (Fig. 2) which collides with target 20 and causes sputtering of Titanium Tungsten material on a wafer on wafer table 24.

When shield 17 is being cleaned, switch 27 connects cathode 22 of DC power supply to PVD chamber 14 which is connected with shield 17. Switch 27 also connects anode 23 to target 20. A gas mixture including a reactive gas, for example NF₃, CF₄, or SF₆, is introduced through port 28. The reactive gas is activated by plasma discharge, for example, by the electric field created by DC power supply 21. The reactive gas etches the material on shield 17. The flow rate of the gasses is approximately 100 sccm. The atmospheric pressure within the PVD chamber can be anywhere between 0.13 Pa (1 milliTorr) 133 Pa (1000 millitorr). The time duration for the etch is typically between one and ten minutes. The resultant reactants are continuously pumped away.

Once the reactive gas has been removed, switch 27 again connects cathode 22 to target 20 and anode 23 to shield 17. Before any new wafers are placed in PVD chamber 14, target 20 may be bombarded by, for example, Argon gas. This sputter cleaning will remove any reactive gas residues on target 20 and expose new target material. The sputter cleaning also serves to seal the surfaces of shield 17 and to act as a getter, removing and trapping gas impurities. During the sputter cleaning the PVD chamber is under the high vacuum normally present when deposition is actually being done on a wafer.

Fig. 2 shows PVD chamber 14, shield 17, and sleeve 16. Chamber 14 is shown to include ports 27, 28, 29, 30, 31, 32, and 33. Port 30 may be used, for example, by vacuum pump 25 or by a roughing pump for intitial pumping to create a vacuum. Port 33 may be, for example, used by a residual gas analyzer. Port 32 may be, for example, used to allow a power line into PVD chamber 14, for example, to power a lamp used in PVD. Port 27 may be, for example, used for venting. Port 29 may be, for example, used as a window. Port 28 may be, for example, used for supplying Argon gas and reactive gas into chamber 14. Wafers are placed in PVD chamber 14 through an opening 31 by automated machinery (not shown). Shield 17 was designed so that for cleaning there is a uniform surface for etching. Also when shield 17 is being cleaned the voltage potential on shield 17 is uniform across all parts of shield 17.

In the preferred embodiment discussed herein a Titanium Tungsten target is utilized. Many other materials may be used in the target, for example, Titanium or Tungsten. The present invention is also useful for cleaning shields for many different processes. When target 20 is aluminum, for example, the process for cleaning would be the same, except that a Chloride containing gas such as Cl₂, or BCl₃ would be used for etching.

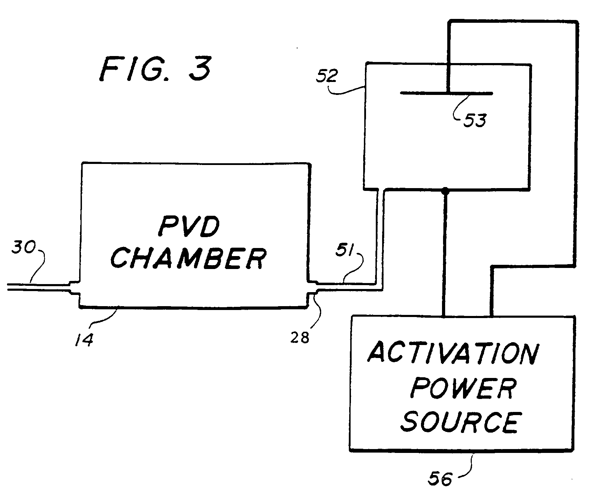

Fig. 3 shows an alternate embodiment of the present invention in which the reactive gas is activated in an upstream activation chamber 52. An activation power source 56 may use either DC or RF power placed on an electrode 53 to activate the reactive gas by plasma discharge. After activation of the reactive gas, the gas mixture containing the reactive gas is pumped through line 51, to PVD chamber 14.

## Claims

1. A method for cleaning a shield (17) within a sputtering chamber (14) to remove material sputtered from a sputtering target (20) and deposited on the shield (17), wherein the target (20) is sputtered by applying a positive voltage to the target (20) relative to the shield (17), and wherein the cleaning is performed while the shield (17) remains within the sputtering chamber (14),
**characterized** by
the steps of:
(a) pumping gas out of the sputtering chamber (14) so as to maintain the gas within the chamber (14) at a vacuum pressure level;
(b) flowing a reactive etchant gas mixture into the sputtering chamber (14);
(c) creating a plasma discharge in the gas; and
(d) applying a positive voltage to the shield (17) relative to the target (20), whereby the shield (17) is etched to remove the material deposited on the shield (17) without substantially etching the target (20), and whereby the pumping exhausts the removed material out of the sputtering chamber (14).

2. The method as in claim 1,
wherein the pumping step includes maintaining the gas at a pressure level between 0.13 Pa (1 milliTorr) and 133 Pa (1 Torr).

3. The method as in claim 1 or 2,
wherein a DC power supply connected between the target (20) and the shield (17) is connected with a first polarity during the sputtering of the target (20) and is connected with a reversed polarity during step (d).

4. The method as in claim 1, 2 or 3,
wherein step (c) is performed within the sputtering chamber.

5. The method as in claim 1, 2 or 3,
wherein step (c) is performed before step (a) within an activation chamber (52) upstream of the sputtering chamber (14).

6. A physical vapor deposition device, comprising:
a sputtering chamber (14);
specimen support means (24) for supporting specimens with the sputtering chamber (14);
a sputtering target (20), placed within the sputtering chamber (14), from which material is deposited on the specimens;
a power supply (21) having a cathode (22) and an anode (23) for applying a positive voltage to the target (20) relative to a shield (17); and
means for cleaning the shield (17) while the shield (17) remains in the sputtering chamber (14),
**characterized** in
that said means comprise:
gas introduction means (26; 51, 52), coupled to the sputtering chamber (14), for introducing a gas mixture which includes a reactive gas into the sputtering chamber (14);
gas activation means (21, 22, 23, 27; 42, 43; 53, 56) for activating the reactive gas by plasma discharge;
pumping means (25) for creating a vacuum in the sputtering chamber (14) at the beginning of a cleaning cycle and for exhausting the gas mixture together with the removed material from the sputtering chamber; and
switching means (27) coupled to the power supply for applying a positive voltage to the shield (17) relative to the target (20) during the cleaning cycle.

7. The device as in claim 6,
wherein the gas activation means include:
upstream activation means (52, 53, 56) for activating the reactive gas before the gas mixture is introduced into the sputtering chamber (14).

8. The device of claim 7,
wherein the upstream activation means (52, 53, 56) include:
an upstream activation chamber (52) through which the gas mixture travels before introduction into the sputtering chamber (14); and
electrical power means (56), coupled to an electrode (53) within the upstream activation chamber (52).

9. The device of claim 8,
wherein the electrical power means (56) are RF power means applying a radio frequency voltage to the electrode (53).

10. The device of any of claims 6 to 9,
wherein the target (20) is a sputtering target comprised of tungsten, titanum, or titanium tungsten, and the reactive gas includes fluorine, or the target (20) is a sputtering target comprised of aluminum and the reactive gas includes chlorine.

## Patentansprüche

1. Ein Verfahren zum Reinigen einer Abdeckung (17) innerhalb einer Sputterkammer (14), um Material zu entfernen, das von einem Sputtertarget (20) abgesputtert und auf der Abdeckung (17) abgeschieden wurde, wobei das Target (20) durch Anlegen einer bzgl. der Abdeckung (17) positiven Spannung an das Target (20) abgesputtert wird und wobei das Reinigen durchgeführt wird, während die Abdeckung (17) in der Sputterkammer (14) verbleibt,
**gekennzeichnet** durch
die Schritte:
(a) Herauspumpen von Gas aus der Sputterkammer (14), damit das Gas innerhalb der Kammer (14) auf einem Vakuumdruckwert gehalten wird;
(b) Einströmenlassen eines reaktiven Ätzgasgemisches in die Sputterkammer (14);
(c) Erzeugen einer Plasmaentladung im Gas; und
(d) Anlegen einer positiven Spannung an die Abdeckung (17) relativ zum Target (20), wodurch die Abdeckung (17) geätzt wird, um das Material abzuätzen, das auf der Abdeckung (17) abgeschieden ist, ohne das Target (20) wesentlich zu ätzen und wodurch das Pumpen das entfernte Material aus der Sputterkammer (14) abführt.

2. Das Verfahren nach Anspruch 1,
bei dem der Pumpschritt das Halten des Gases auf einem Druckwert zwischen 0,13 Pa (1 Millitorr) und 133 Pa (1 Torr) beinhaltet.

3. Das Verfahren nach Anspruch 1 oder 2,
bei dem eine Gleichstromenergiequelle, die mit dem Target (20) und der Abdeckung (17) verbunden ist, während des Sputtern des Targets (20) mit einer ersten Polarität und während des Schrittes (d) mit einer umgekehrten Polarität verbunden ist.

4. Das Verfahren nach Anspruch 1, 2 oder 3,
bei dem der Schritt (c) innerhalb der Sputterkammer durchgeführt wird.

5. Das Verfahren nach Anspruch 1, 2 oder 3,
bei dem der Schritt (c) vor dem Schritt (a) in einer der Sputterkammer (14) vorgeschalteten Aktivierungskammer (52) durchgeführt wird.

6. Eine Vorrichtung zum physikalischen Aufdampfen, die enthält:
eine Sputterkammer (14);
Haltemittel (24) für Probestücke, um Probestücke in der Sputterkammer (14) abzustützen;
ein innerhalb der Sputterkammer (14) untergebrachtes Sputtertarget (20), von dem Material auf die Probestücke abgeschieden wird;
eine Energieversorgung (21) mit einer Kathode (22) und einer Anode (23), zum Anlegen einer positiven Spannung an das Target (20) relativ zu einer Abdeckung (17); und
Mittel zum Reinigen der Abdeckung (17), während die Abdeckung (17) in der Sputterkammer (14) verbleibt,
dadurch **gekennzeichnet**,
daß die Mittel aufweisen:
eine mit der Sputterkammer (14) gekoppelte Gaseinlaßeinrichtung (26; 51, 52) zum Einführen eines ein Reaktionsgas aufweisenden Gasgemisches in die Sputterkammer (14);
eine Gasaktivierungseinrichtung (21, 22, 23, 27; 42, 43; 53, 56) zum Aktivieren des Reaktionsgases mittels einer Plasmaentladung;
eine Pumpeinrichtung (25) zum Erzeugen eines Vakuums in der Sputterkammer (14) zu Beginn eines Reinigungszyklus und zum Abführen des Gasgemisches zusammen mit dem entfernten Material aus der Sputterkammer; und
eine mit der Energieversorgung gekoppelte Schalteinrichtung (27) zum Anlegen einer positiven Spannung an die Abdeckung (17) relativ zum Target (20) während des Reinigungszyklus.

7. Die Vorrichtung nach Anspruch 6,
bei der die Gasaktivierungseinrichtung einschließt:
eine vorgeschaltete Aktivierungseinrichtung (52, 53, 56) zum Aktivieren des Reaktionsgases, bevor das Gasgemisch in die Sputterkammer (14) eingeleitet wird.

8. Die Vorrichtung nach Anspruch 7,
bei der die vorgeschaltete Aktivierungseinrichtung (52, 53, 56) enthält:
eine vorgeschaltete Aktivierungskammer (52) durch die sich das Gasgemisch vor der Einführung in die Sputterkammer (14) bewegt; und
elektrische Energieversorgungsmittel (56), die mit einer Elektrode (53) in der vorgeschalteten Aktivierungskammer (52) verbunden sind.

9. Die Vorrichtung nach Anspruch 8,
bei der die elektrischen Energieversorgungsmittel (56) HF-Energieversorgungsmittel sind, die die Elektrode (53) mit einer Hochfrequenzspannung versorgen.

10. Die Vorrichtung nach einem der Ansprüche 6 bis 9,
bei der das Target (20) ein Sputtertarget ist, das aus Wolfram, Titan oder Wolfram-Titan besteht, und das Reaktionsgas Fluor enthält oder das Target (20) ein Sputtertarget ist, das aus Aluminium besteht, und das Reaktionsgas Chlor enthält.

## Revendications

1. Procédé pour nettoyer un écran (17) à l'intérieur d'une enceinte de dépôt par pulvérisation (14) afin d'enlever le matériau pulvérisé à partir d'une cible de pulvérisation (20) et déposé sur l'écran (17), dans lequel la cible (20) est pulvérisée en appliquant une tension positive à la cible (20) par rapport à l'écran (17), et dans lequel le nettoyage est effectué tandis que l'écran (17) demeure à l'intérieur de l'enceinte de dépôt par pulvérisation (14),
caractérisé par
les étapes consistant à :
(a) pomper le gaz hors de l'enceinte de dépôt par pulvérisation (14) de manière à maintenir le gaz présent à l'intérieur de l'enceinte (14) à un niveau de pression de vide,
(b) faire circuler un mélange gazeux de réactif d'attaque dans l'enceinte de dépôt par pulvérisation (14),
(c) créer une décharge de plasma dans le gaz, et
(d) appliquer une tension positive à l'écran (17) par rapport à la cible (20), d'où il résulte que l'écran (17) est attaqué afin d'enlever le matériau déposé sur l'écran (17) sans sensiblement attaquer la cible (20), et dans lequel le pompage chasse le matériau enlevé hors de l'enceinte de dépôt par pulvérisation (14).

2. Procédé selon la revendication 1,
dans lequel l'étape de pompage comprend l'étape consistant à maintenir le gaz à un niveau de pression compris entre 0,13 Pa (1 milliTorr) et 133 Pa (1 Torr).

3. Procédé selon la revendication 1 ou 2,
dans lequel une alimentation en courant continu raccordée entre la cible (20) et l'écran (17) est raccordée avec une première polarité pendant la pulvérisation de la cible (20) et est raccordée avec une polarité inversée pendant l'étape (d).

4. Procédé selon la revendication 1, 2 ou 3,
dans lequel l'étape (c) est effectuée à l'intérieur de l'enceinte de dépôt par pulvérisation.

5. Procédé selon la revendication 1, 2 ou 3,
dans lequel l'étape (c) est effectuée avant l'étape (a) à l'intérieur d'une enceinte d'activation (52) en amont de l'enceinte de dépôt par pulvérisation (14).

6. Dispositif pour dépôt physique en phase vapeur, comprenant :
une enceinte de dépôt par pulvérisation (14),
des moyens de support de spécimen (24) destinés à supporter des spécimens à l'intérieur de l'enceinte de dépôt par pulvérisation (14),
une cible de pulvérisation (20), placée à l'intérieur de l'enceinte de dépôt par pulvérisation (14), à partir de laquelle du matériau est déposé sur le spécimen,
une alimentation électrique (21) comportant une cathode (22) et une anode (23) destinées à appliquer une tension positive à la cible (20) par rapport à un écran (17), et
des moyens destinés à nettoyer l'écran (17) tandis que l'écran (17) demeure dans l'enceinte de dépôt par pulvérisation (14),
caractérisé en ce que
lesdits moyens comprennent :
des moyens d'introduction de gaz (26 ; 51, 52), raccordés à l'enceinte de dépôt par pulvérisation (14), afin d'introduire un mélange gazeux qui comprend un gaz réactif dans l'enceinte de dépôt par pulvérisation (14),
des moyens d'activation de gaz (21, 22, 23, 27 ; 42, 43 ; 53, 56) pour activer le gaz réactif par décharge de plasma,
des moyens de pompage (25) pour créer un vide dans l'enceinte de dépôt par pulvérisation (14) au début d'un cycle de nettoyage et pour chasser le mélange gazeux en même temps que le matériau enlevé de l'enceinte de dépôt par pulvérisation, et
des moyens de commutation (27) raccordés à l'alimentation électrique afin d'appliquer une tension positive à l'écran (17) par rapport à la cible (20) pendant le cycle de nettoyage.

7. Dispositif selon la revendication 6,
dans lequel les moyens d'activation de gaz comprennent :
des moyens d'activation en amont (52, 53, 56) pour activer le gaz réactif avant que le mélange gazeux soit introduit dans l'enceinte de dépôt par pulvérisation (14).

8. Dispositif selon la revendication 7,
dans lequel les moyens d'activation en amont (52, 53, 56) comprennent :
une enceinte d'activation en amont (52) au travers de laquelle le mélange gazeux circule avant son introduction dans l'enceinte de dépôt par pulvérisation (14), et
des moyens d'alimentation électrique (56) raccordés à une électrode (53) à l'intérieur de l'enceinte d'activation en amont (52).

9. Dispositif selon la revendication 8,
dans lequel les moyens d'alimentation électrique (56) sont des moyens d'alimentation HF appliquant une tension haute fréquence à l'électrode (53).

10. Dispositif selon l'une quelconque des revendications 6 à 9,
dans lequel la cible (20) est une cible de pulvérisation constituée de tungstène, de titane, ou de titane-tungstène, et le gaz réactif comprend du fluor, ou bien la cible (20) est une cible de pulvérisation constituée d'aluminium et le gaz réactif comprend du chlore.
